(19) Europäisches Patentamt
European Patent Office
Office européen des brevets

(11) **EP 3 814 788 B1**

(12) **FASCICULE DE BREVET EUROPEEN**

(45) Date de publication et mention
de la délivrance du brevet:
**21.08.2024 Bulletin 2024/34**

(21) Numéro de dépôt: **19737019.0**

(22) Date de dépôt: **27.06.2019**

(51) Classification Internationale des Brevets (IPC):
***G01R 31/08*** *(2020.01)*

(52) Classification Coopérative des Brevets (CPC):
**G01R 31/08;** G01R 31/088

(86) Numéro de dépôt international:
**PCT/EP2019/067262**

(87) Numéro de publication internationale:
**WO 2020/002561 (02.01.2020 Gazette 2020/01)**

(54) **SYSTEME ET PROCEDE DE LOCALISATION DE DEFAUT SUR UN RESEAU ELECTRIQUE POLIPHASE UTILISANT L'EVOLUTION DE TENSION DIRECTE ET INVERSE**

SYSTEM UND VERFAHREN ZUR FEHLERLOKALISIERUNG IN EINEM MEHRPHASIGEN LEISTUNGSSYSTEM UNTER VERWENDUNG DER ENTWICKLUNG VON VORWÄRTS- UND RÜCKWÄRTSSPANNUNG

SYSTEM AND METHOD FOR FAULT LOCALISATION ON A POLYPHASE POWER SYSTEM USING THE EVOLUTION OF FORWARD AND REVERSE VOLTAGE

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **28.06.2018 FR 1855883**

(43) Date de publication de la demande:
**05.05.2021 Bulletin 2021/18**

(73) Titulaire: **Electricité de France
75008 Paris (FR)**

(72) Inventeur: **DENEUVILLE, Boris
92120 MONTROUGE (FR)**

(74) Mandataire: **Regimbeau
20, rue de Chazelles
75847 Paris Cedex 17 (FR)**

(56) Documents cités:
| | |
|---|---|
| **EP-A1- 0 933 643** | **EP-A1- 2 533 060** |
| **DE-A1- 3 636 367** | **FR-A1- 2 936 378** |
| **FR-A1- 3 028 620** | **IE-A2- S20 050 382** |
| **JP-A- 2004 061 142** | **US-A1- 2008 097 706** |
| **US-A1- 2010 102 824** | **US-A1- 2017 336 465** |

**Description**

**DOMAINE DE L'INVENTION**

La présente invention concerne la localisation de défauts sur des réseaux électriques. Plus particulièrement, l'invention concerne un système de détection et de localisation absolue de défaut avec ou sans rupture de conducteur sur des réseaux d'alimentation électriques triphasés.

**ETAT DE LA TECHNIQUE**

Défauts sur les réseaux électriques :

Les réseaux électriques sont sujets à des défauts qu'il convient d'éliminer le plus rapidement possible.

Un défaut sans rupture de conducteur résulte par exemple :

- d'un contact entre la ligne de distribution et un arbre créant un courant de court-circuit vers la terre ;
- d'un contact mécanique sur un réseau souterrain créant un courant de court-circuit entre phases et/ou vers la terre, par exemple sous forme d'un coup de pioche ;
- de la baisse de la qualité d'isolement d'un câble usé créant un courant de court-circuit entre phases et/ou vers la terre.

Un défaut avec rupture de conducteur se produit en cas d'intempéries par exemple. Les conducteurs de part et d'autre de la rupture peuvent tomber au sol ce qui là encore peut créer des courts-circuits vers la terre.

Pour éliminer le défaut on peut mettre la ligne ou une partie de la ligne en défaut hors tension, ce qui conduit à ne plus alimenter la ligne ou la portion de ligne concernée.

Pour éviter ou limiter ce désagrément, on peut réduire la portion du réseau à mettre hors tension et/ou localiser précisément le défaut pour effectuer les réparations nécessaires et rétablir le service le plus rapidement possible.

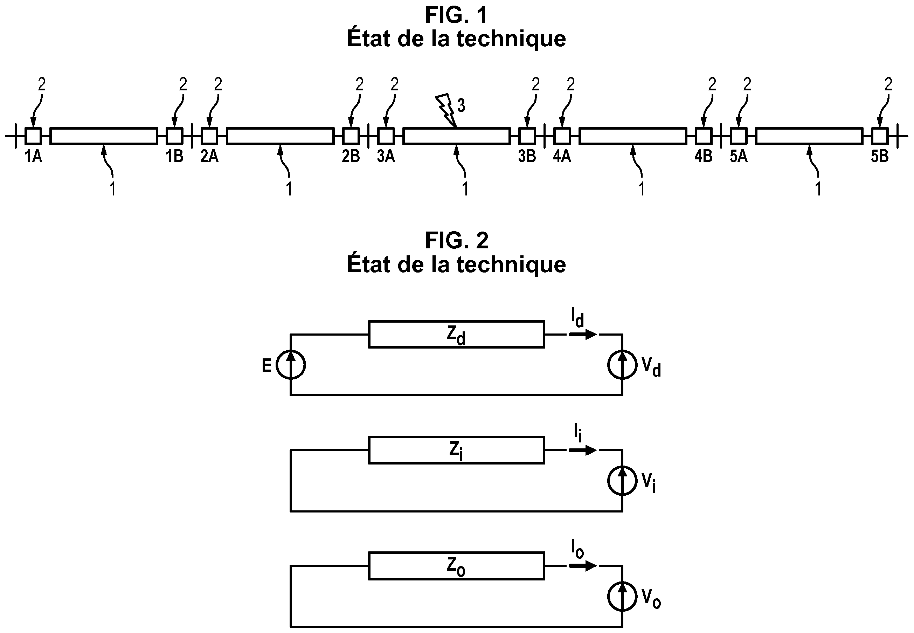

En fait, pour réduire la taille de la portion de réseau à mettre hors tension, il est courant de segmenter le réseau d'électricité en plusieurs zones, afin que l'on puisse surveiller et contrôler le réseau par portions. Chaque zone est encadrée par deux protections. Chaque protection a pour mission de surveiller une zone adjacente. Elle ne déclenche que si un défaut est détecté dans sa zone. Par exemple, on considère théoriquement une ligne 1 comportant 5 zones différentes séparées par des protections 2 permettant d'isoler chaque portion de ligne des autres lignes, comme schématisé sur la figure 1. Chaque zone est délimitée par deux protections. Si le défaut apparaît en troisième zone, en référence à la figure 1 :

- toutes les protections 2 sauf les protections 3A et 3B perçoivent le défaut 3, mais elles ne le localisent pas dans leurs zones. Elles ne déclenchent pas.
- les protections 3A et 3B qui encadrent le défaut perçoivent le défaut 3 et le localisent dans leurs zones. Elles déclenchent alors pour mettre la zone concernée hors tension.

Rappel théorique :

Pour que l'intervention soit effectuée le plus rapidement et le plus efficacement possible, il est nécessaire de localiser précisément le défaut 3.

Pour étudier les réseaux électriques en situation de défaut on peut utiliser une méthode mathématique appelée la transformée de Fortescue permettant de décomposer typiquement un réseau électrique triphasé en trois réseaux monophasés indépendants, dits direct, inverse et homopolaire.

Le changement de la base physique « abc » des tensions $V_a$, $V_b$, $V_c$ (au sens des phases a, b et c), à la base de Fortescue $V_d$, $V_i$, $V_o$ (Direct, Inverse, Homopolaire) se fait via le système d'équations suivant :

$$V_a = V_d + V_i + V_o$$

$$V_b = a^2 V_d + a V_i + V_o$$

$$V_c = a V_d + a^2 V_i + V_o$$

Avec

$$a = e^{j\frac{2\pi}{3}}$$

Tout point d'un réseau triphasé alimenté par une source directe peut être modélisé par la superposition de trois schémas monophasés direct, inverse et homopolaire, comme schématisé sur la figure 2.

$$E = V_d + Z_d * I_d$$

$$0 = V_i + Z_i * I_i$$

$$0 = V_o + Z_o * I_o$$

Avec :

- $V_d$, $V_i$ et $V_o$ : tensions respectivement directe, inverse et homopolaire au point de réseau considéré ;
- $I_d$, $I_i$, $I_o$ : courants respectivement direct, inverse et homopolaire au point de réseau considéré ;

- $Z_d$, $Z_i$ et $Z_o$ : impédances respectivement directe, inverse et homopolaire ;
- E : tension directe équivalente aux générateurs du réseau d'alimentation

Si le réseau est parfaitement équilibré, les composantes de tensions inverse et homopolaire sont nulles : $V_i = V_o = 0$

Dans ce cas, la tension ne comporte qu'une composante directe $V_d$. Les tensions inverse et homopolaire sont nulles.

Si le réseau comporte un défaut 3, on peut avoir des évolutions des tensions directe et inverse à l'endroit du défaut 3. Dans le cas d'un défaut 3 monophasé, au défaut, on a :

$$Vd = \frac{Zi + Zo}{Zd + Zi + Zo} E$$

$$Vi = \frac{-Zi}{Zd + Zi + Zo} E$$

Par ces 2 équations, il apparaît que sur un réseau à très forte puissance de court-circuit, ou un réseau à neutre fortement impédant, isolé ou compensé, $Z_d$ et $Z_i$ sont petits devant $Z_o$, alors la baisse de tension et la hausse de tension inverse liées à l'apparition d'un défaut 3 monophasé sont faibles.

Dans le cas d'un défaut 3 biphasé isolé, au défaut, on a :

$$Vd = Vi = \frac{Zi}{Zd + Zi} E$$

Dans le cas d'un défaut 3 triphasé isolé, au défaut, on a :

$$Vd = Vi = 0$$

Par la suite, on définit le « taux de tension inverse » comme étant égal au rapport entre la tension inverse $V_i$ et la tension nominale du réseau, comme $20000/\sqrt{3}$ pour un réseau haute tension de 20 kV, et « le taux de tension directe » comme étant égal au rapport entre la tenions directe $V_d$ et la tension nominale du réseau. Par la suite, ces grandeurs sont mentionnées pour illustrer des exemples. En revanche, ces paramètres ne sont pas limitatifs et les tensions inverse et directe peuvent être également exploitées par l'invention *per se.*

### Différents modes de localisation des défauts électriques

L'invention peut s'appliquer à deux types de réseaux de distribution : des réseaux maillés et des réseaux non-maillés, ces derniers étant parfois qualifiés de réseaux « radiaux » ou « arborescents ».

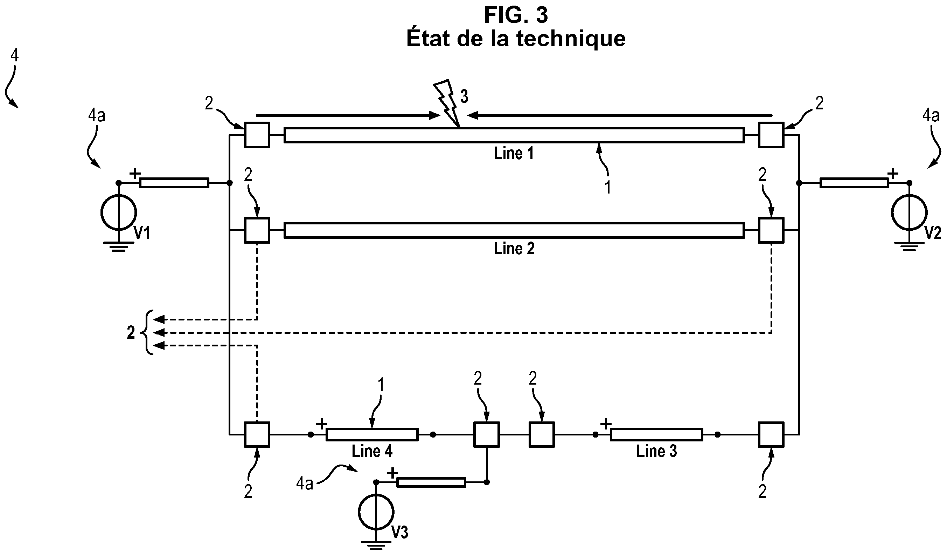

Généralement, les réseaux haute tension (HTB) sont des réseaux maillés 4 comme illustré sur la figure 3. Autrement dit, un point du réseau haute tension est connecté à au moins 2 sources 4a afin qu'il soit toujours alimenté, même si l'une des deux sources 4a n'est pas fonctionnelle ou si une portion de ligne est mise hors tension.

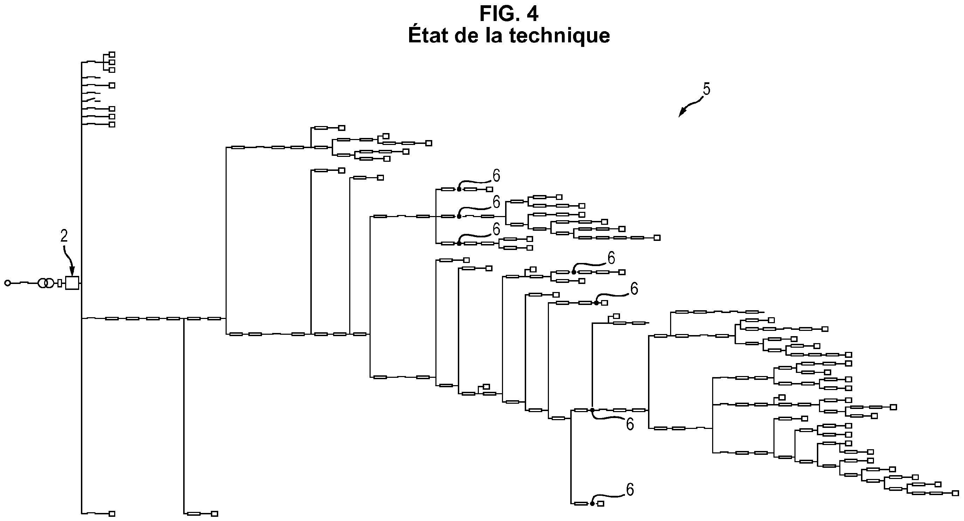

Les réseaux moyenne (HTA) et basse tension (BT) sont généralement non-maillés 5 comme illustré sur la figure 4 et disposent d'une géométrie arborescente. Dans ce cas, l'ouverture d'un élément du réseau par exemple par un disjoncteur provoque la mise hors tension de toute la zone en aval.

Dans le cas du réseau maillé 4 comportant plusieurs sources 4a haute tension V1, V2, V3, il existe des relais de protection 2 répartis sur les différents tronçons de ligne, généralement aux extrémités des lignes, capables de localiser les défauts électriques 3, comme illustré sur la figure 3. C'est le cas par exemple des protections de distance.

Les protections 2 de distance mesurent les courant et tension électrique à l'endroit où elles sont installées. Un calcul d'impédance à partir des mesures des courants et des tensions permet de déterminer à quelle distance se situe un défaut 3, connaissant l'impédance linéique des lignes 1. Les problèmes posés par ces relais sont d'abord qu'il faut mesurer des courants, ce qui nécessite d'installer des transformateurs de courant (bobinage autour de la ligne 1), et c'est une solution coûteuse et complexe en termes d'installation.

Ensuite, il est difficile, voire impossible d'utiliser des protections de distance sur des réseaux arborescents 5 et hétérogènes qui possèdent différents types de conducteurs, donc d'impédances différentes. Par ailleurs, il est impossible de distinguer des défauts 3 à la même distance 6 du relais de protection 2, mais qui sont sur des branches différentes dans le cas d'un réseau arborescent 5, tel qu'illustré sur la figure 4.

Par ailleurs, la détection et la localisation de défauts avec rupture de conducteurs dans les réseaux non-maillés pour lesquels, du côté de la source, les conducteurs ne sont pas en contact avec la terre, sont très difficiles à détecter car ils sont très résistants.

A ce titre le document FR 2976 363 et son équivalent EP 2 533 060 divulguent un dispositif de détection et de localisation relative d'un défaut 3 provenant d'une rupture de conducteur uniquement, le dispositif ne fonctionnant pas en cas de non rupture de conducteur, dans un réseau électrique moyenne tension 5 en utilisant une comparaison de la valeur de la tension inverse à un seuil puis, pour la détection relative en amont ou en aval du point de mesure, la comparaison de l'amplitude des tensions phase-neutre en basse tension à la moyenne des amplitudes de toutes les tensions phase-neutre en basse tension, puis enfin, la comparaison de l'amplitude des tensions phase-neutre en basse tension à un seuil. La mise en oeuvre de ce processus requiert de mesurer les tensions simples du réseau basse tension, ce qui implique bien évidemment que le neutre soit sorti, et quand bien même il l'est, il est nécessaire dans le cas d'un réseau triphasé d'équiper 4 conducteurs, c'est-à-dire 3 phases et un neutre, alors que la présente invention n'utilise que les tensions directes et inverses qui peuvent être calculées uniquement en mesurant les 3 tensions composées et donc en n'équipant que 3 conducteurs, ce qui bien sûr en supposant que de nombreux postes HTA-BT doivent être instrumentés représente une économie considérable. Aussi et cependant, l'application de l'enseignement de ces documents reste complexe. Ces documents proposent de considérer qu'un défaut est détecté lorsque la tension inverse dépasse un seuil de déclenchement et de tenter alors de localiser le défaut en amont ou en aval d'un point de mesure, en mesurant les amplitudes des tensions simples, par exemple la valeur efficace RMS, pour chaque phase et en calculant leur moyenne arithmétique, puis en considérant que si au moins deux valeurs de normes dépassent la moyenne alors le défaut est en amont du point de mesure, mais sinon on calcule la valeur minimale des amplitudes de tension de phase et si cette valeur minimale dépasse un seuil fixé sous forme d'un pourcentage de la valeur nominale du réseau, le défaut est en amont du point de mesure et sinon il est en aval. Ces documents indiquent d'ailleurs en outre que bien que des études théoriques indiquent la possibilité d'utiliser la tension inverse et/ou la tension homopolaire sur un réseau MT, cependant les problèmes inhérents à la mesure de la tension sur des conducteurs de phase moyenne tension restent entiers.

Les moyens proposés dans les documents FR 2 976 363 et EP 2 533 060 ne fonctionnent qu'en cas de rupture de conducteur sur le réseau électrique. Ils ne fonctionnent pas pour des défauts sans rupture de conducteur, qui sont aussi l'objectif de la présente invention.

Le document FR 3 028 620 décrit d'autres moyens de localisation de défauts monophasés dans un réseau de distribution haute tension qui reposent sur l'équation de la boucle de défaut formée entre le poste source (et itérativement jusqu'à l'entrée du tronçon en défaut) et la résistance de défaut.

Le document FR 2 936 378 décrit un dispositif de signalisation de défaut comprenant des capteurs de courant. Les moyens décrits dans ce document ne donnent pas totalement satisfaction du fait notamment que l'installation de capteurs de courant sur un réseau électrique reste complexe et coûteuse.

On trouve d'autres solutions proposées pour la détection de défauts sur un réseau électrique dans les documents US 2008/097706, JP 2004 061142, US 2017/336465, EP 0933643, DE 36 36 367 et IE S20 050 382.

## EXPOSE DE L'INVENTION

Dans le contexte résultant de l'état de la technique, la présente invention a pour but de proposer de nouveaux moyens permettant d'améliorer les performances de détection de défaut avec ou sans rupture de conducteur sur des lignes de distribution électrique.

Un but de l'invention est en particulier de proposer un système permettant de localiser un défaut avec ou sans rupture de conducteur dans un réseau d'électricité quelle que soit la topologie de réseau, contrairement à une méthode de détection de défaut conventionnelle.

La présente invention a en particulier pour but de permettre une détection rapide, fiable et précise de défaut avec ou sans rupture de conducteur sur une ligne d'alimentation électrique, sans nécessiter des équipements coûteux.

Le système selon l'invention est défini par la revendication 1.

Le système selon l'invention est avantageusement complété par les caractéristiques définies dans la revendication 15.

Un tel système a l'avantage de ne pas nécessiter des mesures de courant, qui est une solution coûteuse en termes de dimensionnement de réseau.

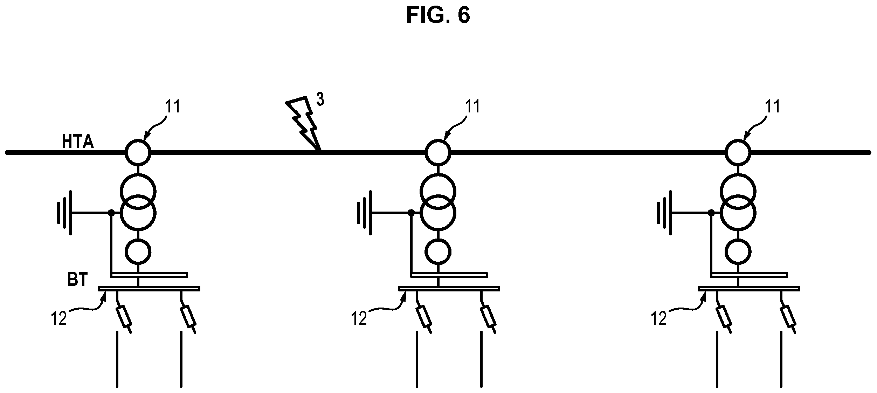

Par ailleurs, les taux de tension directs et inverses en un point du réseau sont directement transmis aux tensions inférieures. Par exemple sur la figure 6 les taux mesurés aux points 11 du réseau sont transmis aux réseaux BT 12 connectés aux points 11. Or ces réseaux BT disposent souvent de points de mesures déjà installés pour d'autres besoins comme le comptage de l'énergie distribuée ou la surveillance de la qualité de la tension. Ces points de mesure peuvent donc être réutilisés, ce qui bien sûr présente l'intérêt de disposer de point de mesure supplémentaires en limitant les coûts associés.

L'invention concerne également un procédé de détection d'un défaut dans un réseau électrique moyenne et/ou basse tension tel que défini par la revendication 2.

Le procédé selon l'invention est avantageusement complétée par les caractéristiques définies dans les revendications dépendantes 2 à 14.

Un tel procédé a l'avantage de localiser précisément et rapidement le défaut dans un réseau d'électricité à un point de mesure près. Ainsi la zone mise hors tension pour isoler le défaut peut être réduite au minimum si des organes d'ouverture sont installés le long de la ligne, et la recherche du défaut est très rapide car l'exploitant en connaît la localisation.

Aussi un tel procédé à l'avantage d'être applicable aux réseaux maillés ou non.

## DESCRIPTION DES FIGURES

D'autres caractéristiques, buts et avantages de l'invention ressortiront de la description qui suit, qui est purement illustrative et non limitative, et qui doit être lue en regard des dessins annexés sur lesquels :

- La figure 1 déjà présentée, illustre de façon schématique une protection classique de réseau en plusieurs segments ;
- La figure 2 déjà présentée, illustre un réseau connu qui comprend une seule force électromotrice, décomposé en trois composantes de tension et de courant mettant en évidence la superposition de trois régimes correspondants chacun à l'un des systèmes direct, inverse et homopolaire ;
- La figure 3 déjà présentée, illustre un mode de réalisation connu d'un réseau maillé et de protections de distance ;
- La figure 4 déjà présentée, représente un réseau arborescent connu comportant plusieurs points équidistants du relais de protection ;
- La figure 5 illustre schématiquement le principe de l'invention ;
- La figure 6 représente le principe de localisation d'un défaut en HTA en utilisant les mesures effectuées en HTA et/ou en BT ;
- La figure 7 illustre un organigramme d'un procédé de localisation des défauts utilisés pour détecter un extrémum parmi les signaux issus des capteurs répartis sur le réseau de distribution électrique conformément à l'invention ;
- La figure 8 représente un réseau de distribution maillé conforme à l'invention comportant plusieurs noeuds et lignes ;
- Les figures 9a et 9b représentent respectivement des résultats de mesures de taux de tension directe et inverse collectées à partir d'un réseau maillé selon la figure 8 ;
- La figure 10 représente un réseau de distribution arborescent conforme à l'invention comportant plusieurs noeuds et lignes ;

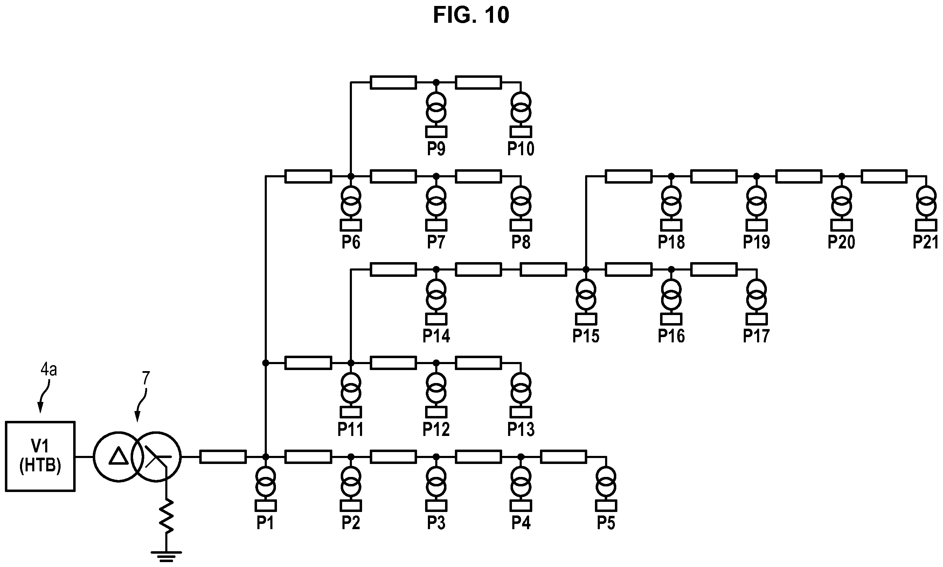

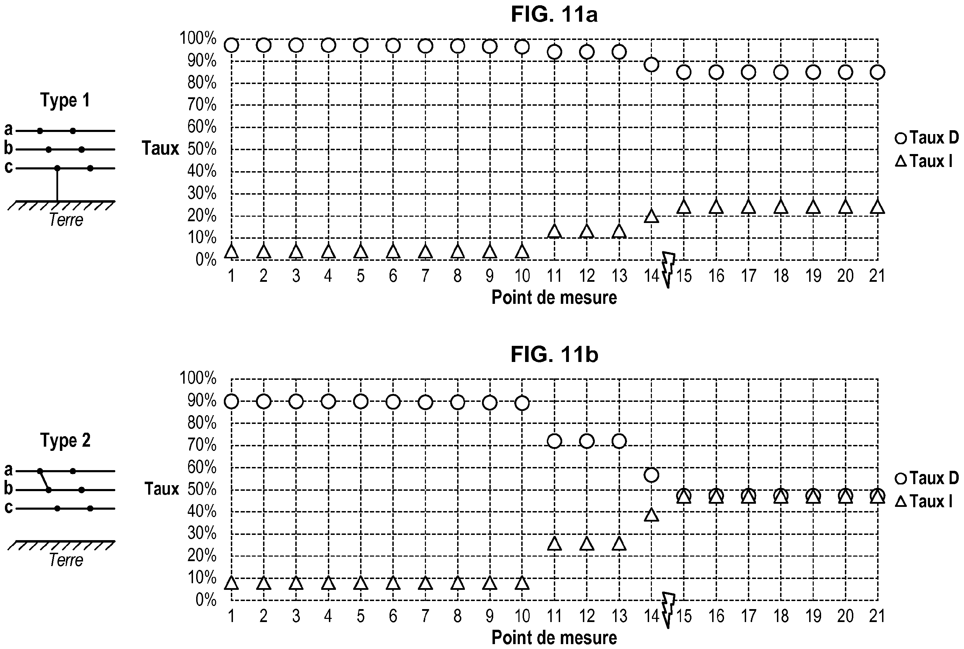

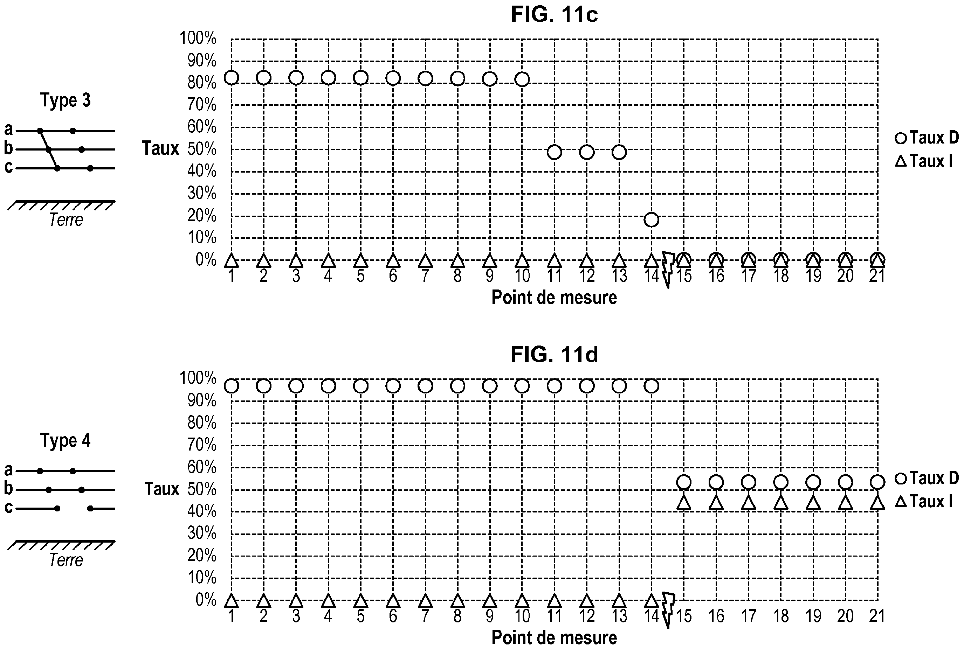

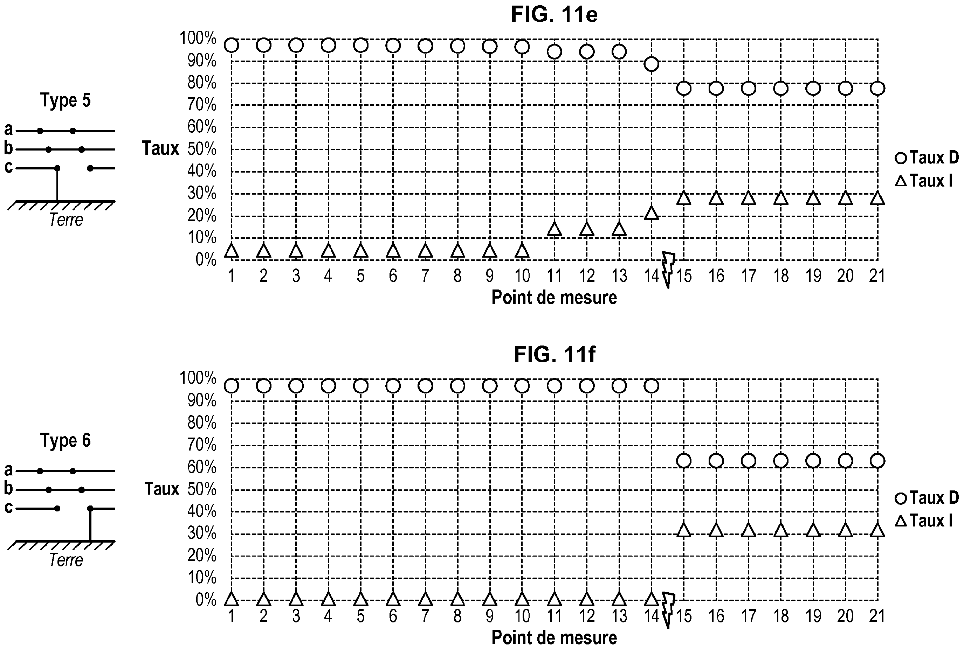

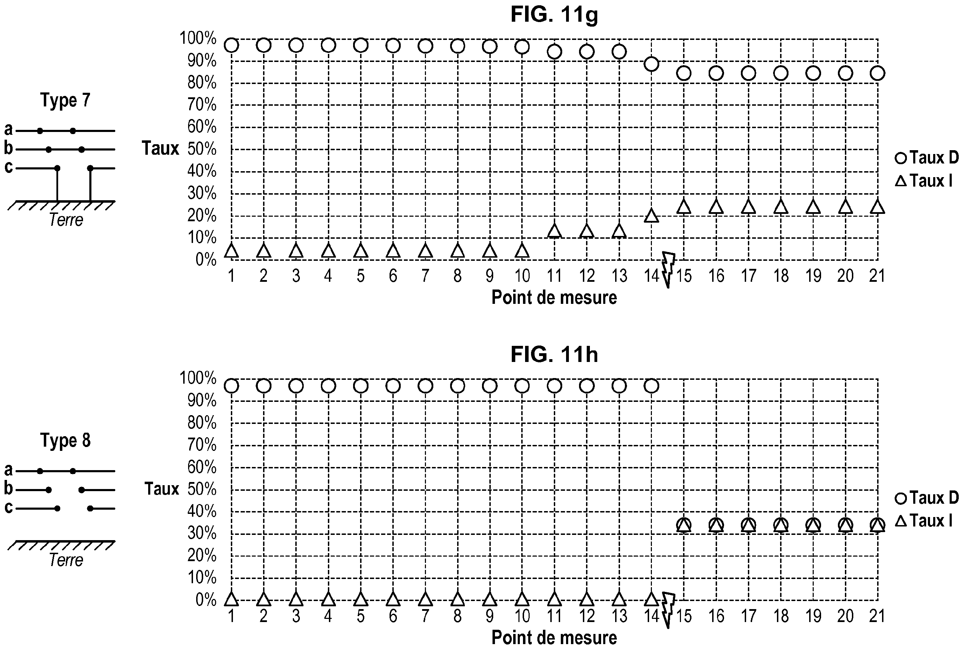

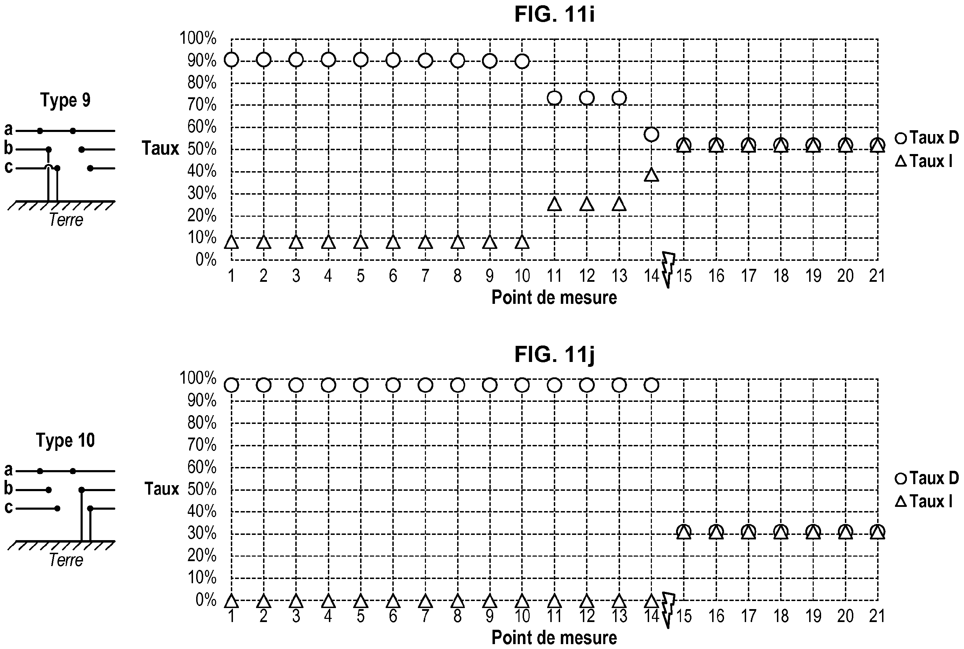

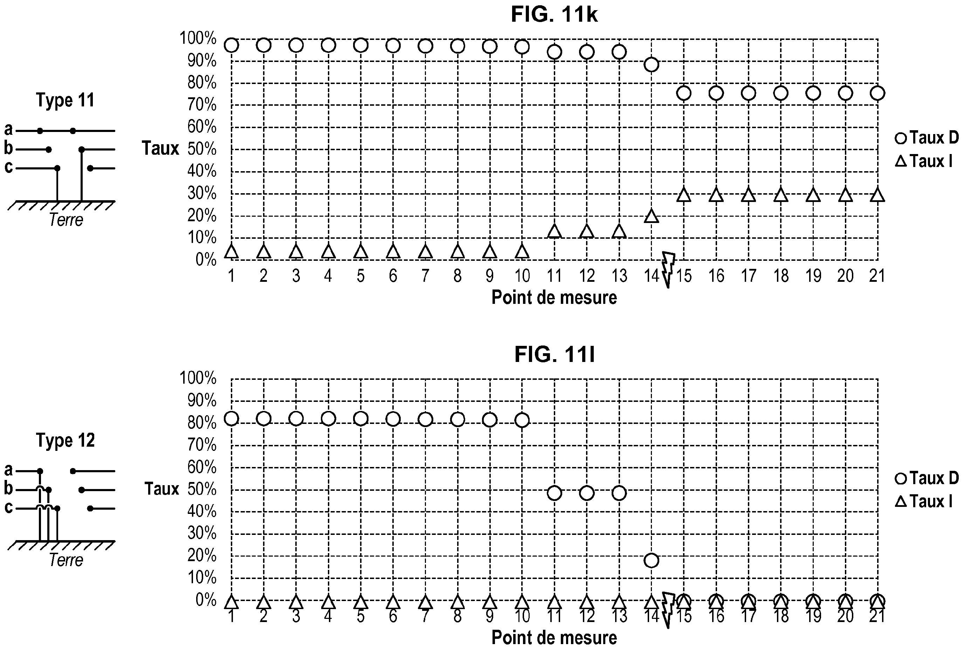

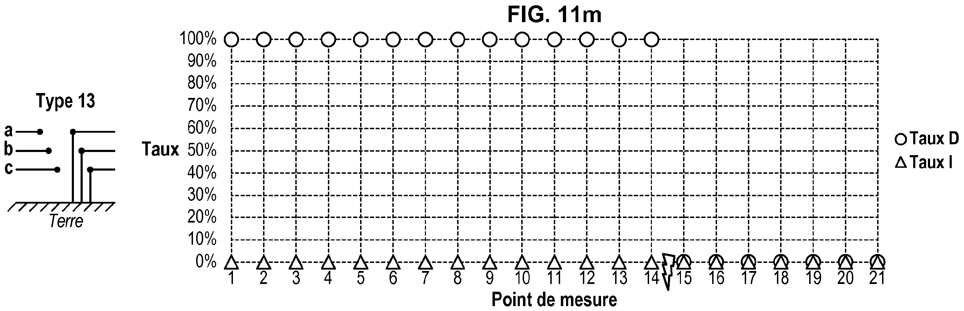

- Les figures 11a à 11m représentent des résultats de mesures de taux de tension directe et inverse collectées à partir d'un réseau non maillé (arborescent) selon la figure 10 ; plus précisément la figure 11a correspond au cas d'un défaut monophasé par mise à la terre d'une phase, la figure 11b correspond au cas d'un défaut biphasé par liaison entre deux phases, la figure 11c correspond au cas d'un défaut triphasé par liaison entre trois phases, la figure 11d correspond au cas d'un défaut monophasé par rupture d'une phase, la figure 11e correspond au cas d'un défaut monophasé par mise à la terre d'une phase et rupture en aval de la même phase, la figure 11f correspond au cas d'un défaut monophasé par mise à la terre d'une phase et rupture en amont de la même phase, la figure 11g correspond au cas d'un défaut monophasé par rupture d'une phase et mise à la terre en amont et en aval de la rupture de la même phase, la figure 11h correspond au cas d'un défaut biphasé par rupture de deux phases, la figure 11i correspond au cas d'un défaut biphasé par rupture de deux phases et mise à la terre de ces deux phases en amont des ruptures, et la figure 11j correspond au cas d'un défaut biphasé par rupture de deux phases et mise à la terre de ces deux phases en aval des ruptures.

Sur l'ensemble des figures, les éléments similaires portent des références identiques.

**DESCRIPTION DETAILLEE DE L'INVENTION**

Système selon l'invention

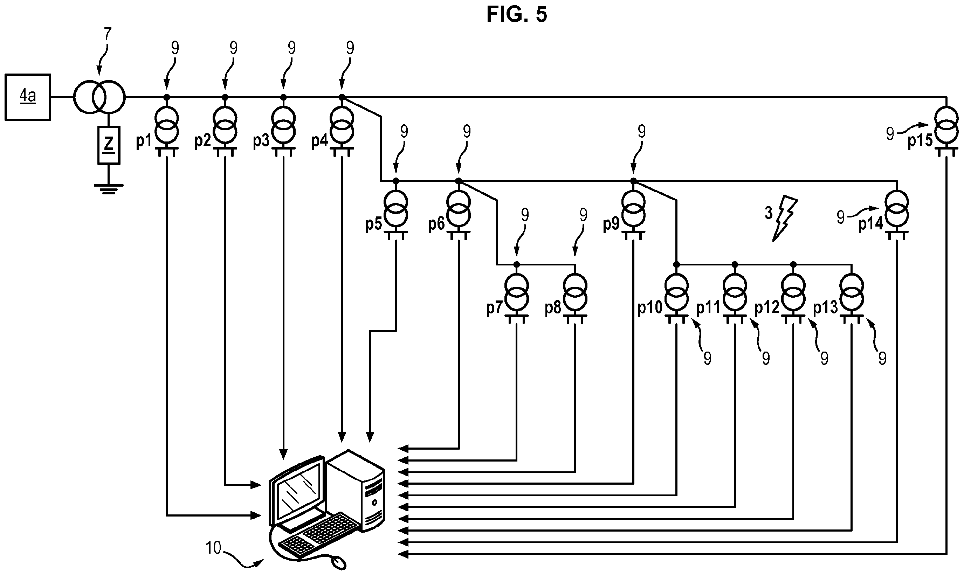

Un système de détection d'un défaut 3 dans un réseau d'électricité 5 polyphasé conforme à l'invention est présenté sur la figure 5.

Dans un mode de réalisation, un réseau d'électricité 5 comprend de l'amont vers aval une source électrique 4a provenant du réseau haute tension 4 HTB à 63 kV, un transformateur 7 permettant de convertir la haute tension vers la moyenne tension HTA à 20 kV, 15 postes moyenne-basse tension 9 HTA-BT équipés de transformateurs permettant de convertir la moyenne tension vers une basse tension BT à 400 V et un calculateur décentralisé 10 qui communique avec chaque poste HTA-BT 9.

Comme indiqué précédemment au niveau de chaque poste 9 un capteur mesure un paramètre représentatif de la tension directe et/ou de la tension inverse au niveau de ce capteur respectif.

Par ailleurs le calculateur qui reçoit les données issues des capteurs précités analyse les signaux issus des différents capteurs représentatifs de la tension directe et/ou de la tension inverse au niveau de chaque capteur respectif, recherche un extremum parmi les signaux issus des capteurs et localise un défaut au niveau du capteur correspondant à cet extremum.

En référence à la figure 6, le système de mesure selon l'invention est capable de localiser le défaut 3 en HTA en utilisant les mesures effectuées en HTA 11 et/ou en BT 12. Cela procure à l'invention un avantage certain car dans les cas des réseaux 5 HTA par exemple, l'invention peut utiliser les points de mesure déjà installés en HTA ou en BT, et notamment :

- des « Concentrateurs » de compteurs communicants (selon la terminologie anglaise « smarts meters ») BT installés dans les postes HTA-BT, du côté BT 12. Ces derniers mesurent les tensions en réseau 5 basse tension. En particulier, ils mesurent les trois tensions phases-neutre ou trois tensions phase-phase. En outre, ils disposent d'un calculateur capable de calculer les valeurs de tension dans la base de Fortescue, en particulier les tensions directes et inverses.
- des Compteurs communicants triphasés des clients BT.

En dehors des cas de défauts 3, les tensions des réseaux 4, 5 sont correctement équilibrées : les tensions inverses sont proches de 0%. En effet pour l'Europe la norme NF EN 50160 stipule que, dans le cas de la tension inverse :

***Dans les conditions normales d'exploitation, pour chaque période d'une semaine, 95 % des valeurs efficaces moyennées sur 10 min de la composante inverse de la tension d'alimentation doivent se situer entre 0 % et 2 % de la composante directe.***

La présence d'un défaut crée au contraire une montée du taux de tension inverse et indique une anomalie dans un des postes du réseau 4, 5.

Les points de mesure mesurent en permanence les tensions directes et inverses. Ces mesures sont réalisées selon un pas de temps plus petit que la durée minimale d'élimination d'un défaut 3 sur la ligne 1 considérée, soit la temporisation du relais de protection 2 du départ typiquement :

- De l'ordre de 400 ms en HTA.
- De l'ordre de quelques secondes en BT pour les lignes 1 protégées avec des fusibles.

Dès que :

- Le taux de tension inverse est supérieur à un seuil de déclenchement paramétrable, par exemple supérieur à 2 %,
- Et/ou le taux de tension directe est inférieur à un seuil de déclenchement paramétrable, par exemple 90 %,

les valeurs des taux directs et inverse mesurés sont envoyés par un moyen de télécommunication au calculateur décentralisé 10.

Notons que les seuils de déclenchement sont paramétrables, car le taux de tension inverse (ou directe) dépend du régime de neutre du réseau 4, 5 (neutre Z = 40 Ohms, neutre Z = 12 Ohms etc.). Le seuil peut être baissé (ou augmenté) si le réseau 4, 5 est bien équilibré.

Procédé selon l'invention

Le calculateur décentralisé 10 positionne les valeurs de tensions directe et/ou inverses pour tous les postes 9 du réseau.

Le calculateur peut procéder à la localisation de la position du défaut 3 et procéder à la reprise partielle du service, aux réparations éventuelles et à la reprise totale du service. En cas de réseaux 4, 5 dont les défauts 3 à la terre sont susceptibles d'être auto-extincteurs, comme dans le cas des réseaux 4, 5 munis de ré-enclencheurs et des réseaux 4, 5 à neutre compensé, l'exploitant peut demander au calculateur de restituer les zones de réseaux 4, 5 sur lesquelles le plus de défauts se sont produits. L'exploitant peut intervenir pour éviter que ces défauts 3 n'apparaissent, ce qui évite une gêne pour les utilisateurs du fait que ces défauts se transforment souvent de fugitifs et auto-extincteurs à permanents, ce qui entraînerait une mise hors tension du réseau 4, 5.

Le calculateur dispose d'une connaissance de la topologie du réseau ainsi que de la longueur des lignes.

Pour chaque portion de réseau délimitée par 2 points de mesure m et n (→ il n'y a pas d'autre point de mesure entre m et n), le calculateur connaît :

- $L(m, n)$ la longueur de la portion entre les points m et n
- $Taux\_I(m)$ et $Taux\_D(m)$ les taux de tension inverses et directes remontés par le point de mesure m.

Pour chaque portion de réseau délimitée par 2 points de mesure m et n, l'invention calcule l'évolution des taux directs EVOL_D et inverse EVOL_I par unité de longueur, définis par

$$EVOL\_D \quad = \frac{Taux\_D_{(m)} - Taux\_D(n)}{L(m,n)}$$

$$EVOL\_I \quad = \frac{Taux\_I_{(m)} - Taux\_I(n)}{L(m,n)}$$

Soit DELTA_EVOL_TAUX_MINI une valeur paramétrable. Cette grandeur est la valeur en dessous de laquelle une évolution de taux est considérée comme nulle.

Aussi, pour un réseau non maillé, si deux points de mesures sont aux extrémités d'un tronçon dont le taux est inférieur à DELTA_EVOL TAUX_MINI, alors dans le procédé qui suit, on considère que le point de mesure ayant le taux inverse maximum et le taux direct minimum est le point de mesure situé du côté de la source.

L'analyse sur la base des dérivées par unité de longueur des signaux mesurés, comme indiqué ci-dessus, permet de s'affranchir de l'influence parasite de sources de production de faible puissance connectées sur le réseau, par exemple de sources photovoltaïques, car ces dernières sont susceptibles de monter localement la tension directe et baisser la tension inverse.

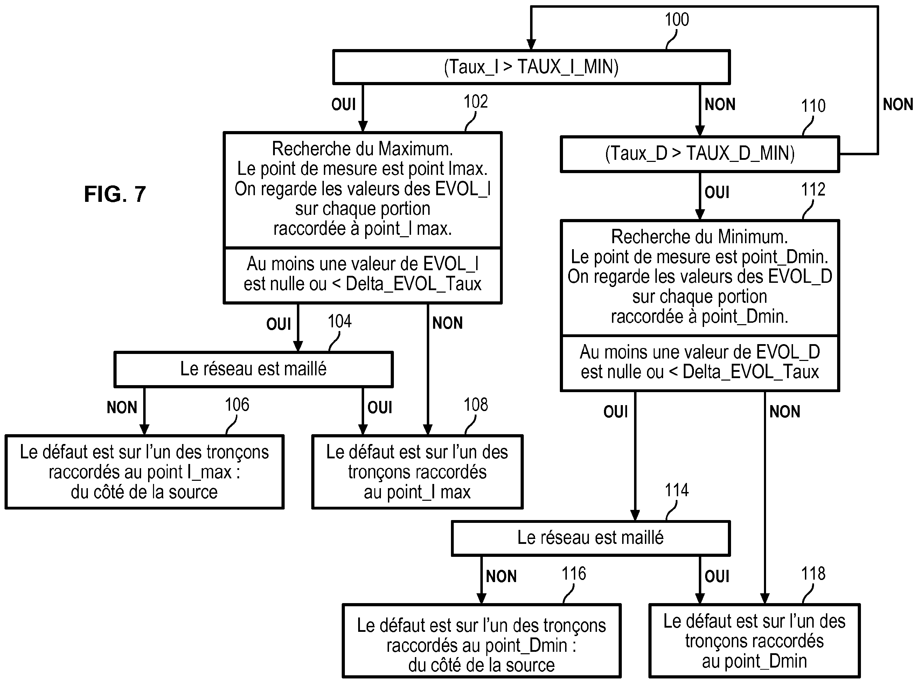

Sur la figure 7, on a illustré un mode de réalisation du procédé selon l'invention comprenant les étapes suivantes pour localiser le défaut :

- Vérifier la supériorité d'au moins un taux de tension inverse Taux I par rapport à un premier seuil paramétrable TAUX_I_MIN (étape 100),

    - si la tension inverse d'au moins un taux Taux_I est supérieure au seuil TAUX_I_MIN, recherche du maximum entre les différents points de mesure, sur chaque portion du réseau raccordée à un point de mesure comme indiqué précédemment (étape 102). Le point de mesure qui correspond à ce maximum est référencé POSTE_I_MAX.- si au moins une valeur de dérivée EVOL_I est nulle ou inférieure à un seuil DELTA_EVOL_TAUX_MINI, recherche du type de réseau pour déterminer si le réseau est un réseau maillé (étape 104),

- si le réseau n'est pas un réseau maillé, l'on considère que le défaut est sur le tronçon raccordé au point de mesure point Imax et situé du côté de la source par rapport à ce point de mesure (étape 106)

- si au contraire le réseau est un réseau maillé, les étapes 102 et 104 sont suivies d'une étape 108 au cours de laquelle l'on considère seulement que le défaut est sur l'un des tronçons raccordés au point de mesure point Imax.

Lorsque l'étape 100 d'origine conduit à un résultat négatif, le procédé opère une étape 110 qui consiste à vérifier si l'évolution de la tension directe Taux D est supérieure à un seuil paramétrable Taux D $_{MIN}$.

Dans la négative le procédé se reboucle par l'étape 100.

Dans l'affirmative au contraire le procédé se poursuit par des étapes 102, 104, 106 et 108 comparables aux étapes précites 112, 114, 116 et 118.

Ainsi :

- si l'évolution de la tension directe Taux D est supérieure au seuil Taux D $_{MIN}$, recherche du minimum entre les différents points de mesure sur chaque portion du réseau raccordée à un point de mesure comme indiqué précédemment (étape 112). Le point de mesure qui correspond à ce minimum est référencé point Dmin.

- si au moins une valeur de dérivée EVOL_D est nulle ou inférieure à un seuil DELTA_EVOL_TAUX_MINI, recherche du type de réseau pour déterminer si le réseau est un réseau maillé (étape 114),

- si le réseau n'est pas un réseau maillé, l'on considère que le défaut est sur le tronçon raccordé au point de mesure point Dmin et situé du côté de la source par rapport à ce point de mesure (étape 116)

- si au contraire le réseau est un réseau maillé, les étapes 112 et 114 sont suivies d'une étape 118 au cours de laquelle l'on considère seulement que le défaut est sur l'un des tronçons raccordés au point de mesure point Dmin.

Résultats des tensions mesurées au niveau des postes

Deux exemples de réseaux 4, 5 en défaut sont considérés pour l'application du procédé à la recherche d'un extrémum de tension inverse et/ou directe.

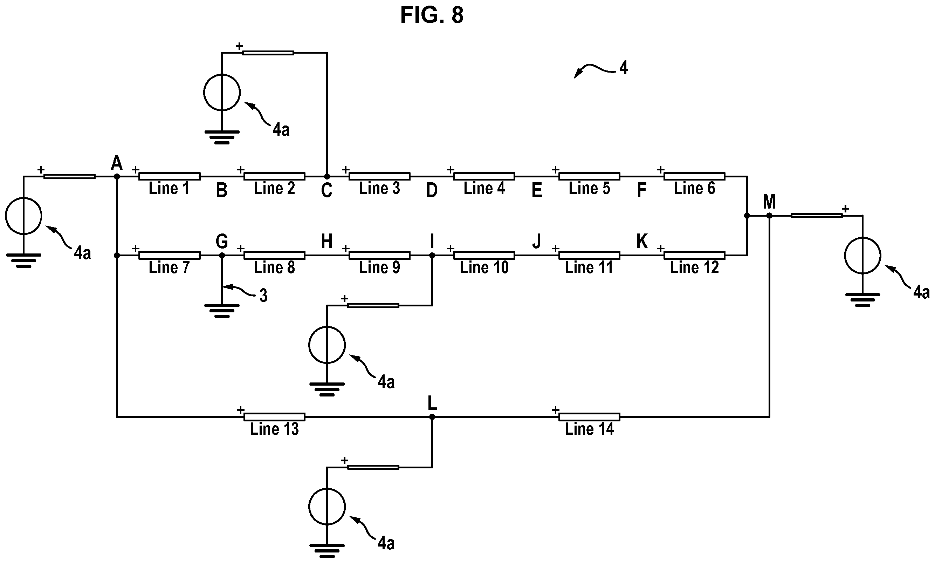

D'abord, on considère un réseau maillé 4 à 225 kV en référence à la figure 8. Le réseau 4 comporte 5 sources 4a avec une puissance de court-circuit de 500 MVA. Les 5 sources 4a alimentent deux portions de 6 lignes et une portion de deux lignes parallèles entre elles. Les noeuds séparant chaque section de ligne sont nommés selon l'ordre alphabétique allant de A à M. Chaque section de ligne représente 10 km de ligne aérienne. Les noeuds A, B, C, D, E, F, M sont sur la même ligne et les noeuds A, G, H, I, J, K, M sont sur la même ligne. L'on suppose que au noeud G apparaît un défaut 3 monophasé (phase-terre), puis un défaut 3 biphasé.

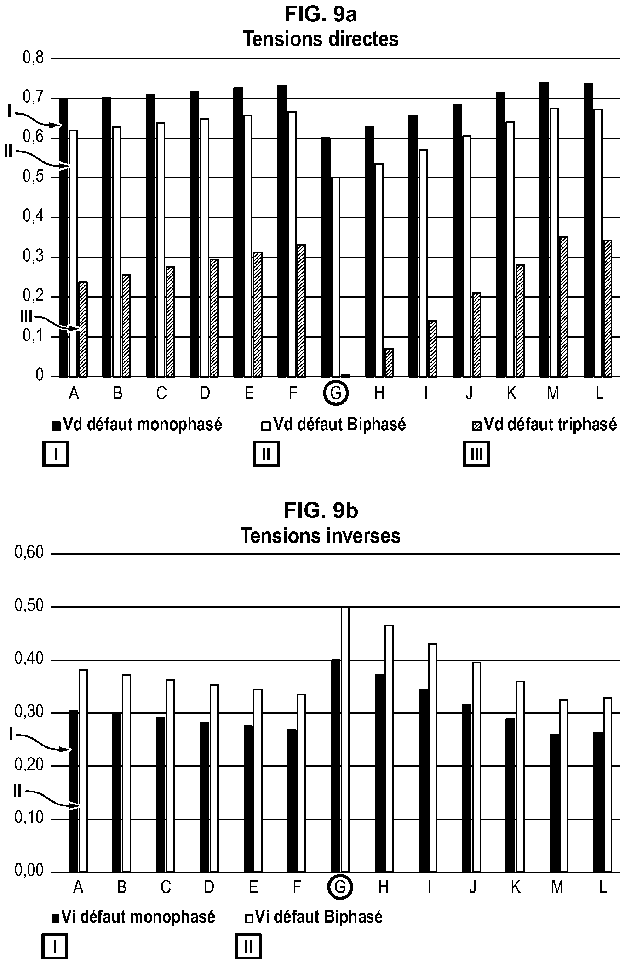

Les tensions directe et inverse en pourcentage de leurs valeurs nominales sont respectivement présentées sur les figures 9a et 9b. Notamment, on notera qu'au noeud où le défaut 3 apparaît (le noeud G), le premier minimum en taux de tensions directes de la ligne en référence à la figure 9a correspond au premier maximum en taux de tensions inverses en référence à la figure 9b.

Maintenant, on considère un réseau arborescent 5 en référence à la figure 10. De l'amont vers l'aval, le réseau 5 comporte une source 4a très haute tension V1, un poste source 7 (transformateur haute-moyenne tension), une pluralité de lignes constituant l'arborescence pour avoir au total 22 lignes et 21 postes HTA-BT avec 200 kW de charge qui sont à divers endroits d'arborescences, soient de P1 à P21. Dans cet exemple, on suppose qu'un défaut de type monophasé (phase-terre) avec ou sans rupture de conducteur, ou biphasé avec ou sans rupture de conducteur, ou triphasé avec ou sans rupture de conducteur, apparaît entre les postes P14 et P15, sachant que les postes P15 à P21 sont sur la même branche de l'arborescence.

Un résultat de taux de tension pour un mode de mise à la terre du neutre résistif de 40 Ohms du transformateur du poste source 7 est traité. Cette fois-ci encore, à l'endroit où le défaut 3 se trouve (entre postes P14 et P15), le premier minimum en taux de tensions directes correspond au premier maximum en taux de tensions inverses comme le montrent les figures 11a à 11m.

Les figures 11a à 11m démontrent que le procédé de détection et de localisation de défaut proposé dans le cadre de la présente invention est opérationnel tant pour des défauts sans rupture de conducteur que pour des défauts résultant de la rupture d'au moins un conducteur.

Par ailleurs, on note que les valeurs des taux de tensions sont les mêmes pour tous les postes 9 en aval du défaut (P15 à P21), et donc pour ces tronçons les évolutions de tension ou de taux de tension sont nulles. Ce résultat est concordant avec le fait que le réseau non-maillé 5 ne comporte qu'une source 4a et que le défaut 3 se situe en amont du point de mesure.

Ces résultats prouvent que le procédé et le système selon l'invention permettent de localiser la position du défaut 3 en recherchant l'extrémum de tensions inverse et/ou directe, pour deux types de topologie de réseau : réseau maillé 4 et réseau non-maillé 5.

- si au contraire le réseau est un réseau maillé, les étapes 102 et 104 sont suivies d'une étape 108 au cours de laquelle l'on considère seulement que le défaut est sur l'un des tronçons raccordés au point de mesure point Imax.

Lorsque l'étape 100 d'origine conduit à un résultat négatif, le procédé opère une étape 110 qui consiste à vérifier si l'évolution de la tension directe Taux D est supérieure à un seuil paramétrable Taux D $_{MIN}$.
Dans la négative le procédé se reboucle par l'étape 100.
Dans l'affirmative au contraire le procédé se poursuit par des étapes 102, 104, 106 et 108 comparables aux étapes précités 112, 114, 116 et 118.
Ainsi :

- si l'évolution de la tension directe Taux D est supérieure au seuil Taux D $_{MIN}$, recherche du minimum entre les différents points de mesure sur chaque portion du réseau raccordée à un point de mesure comme indiqué précédemment (étape 112). Le point de mesure qui correspond à ce minimum est référencé point Dmin.
- si au moins une valeur de dérivée EVOL_D est nulle ou inférieure à un seuil DELTA_EVOL_TAUX_MINI, recherche du type de réseau pour déterminer si le réseau est un réseau maillé (étape 114),
- si le réseau n'est pas un réseau maillé, l'on considère que le défaut est sur le tronçon raccordé au point de mesure point Dmin et situé du côté de la source par rapport à ce point de mesure (étape 116)
- si au contraire le réseau est un réseau maillé, les étapes 112 et 114 sont suivies d'une étape 118 au cours de laquelle l'on considère seulement que le défaut est sur l'un des tronçons raccordés au point de mesure point Dmin.

### Résultats des tensions mesurées au niveau des postes

Deux exemples de réseaux 4, 5 en défaut sont considérés pour l'application du procédé à la recherche d'un extrémum de tension inverse et/ou directe.
D'abord, on considère un réseau maillé 4 à 225 kV en référence à la figure 8. Le réseau 4 comporte 5 sources 4a avec une puissance de court-circuit de 500 MVA. Les 5 sources 4a alimentent deux portions de 6 lignes et une portion de deux lignes parallèles entre elles. Les noeuds séparant chaque section de ligne sont nommés selon l'ordre alphabétique allant de A à M. Chaque section de ligne représente 10 km de ligne aérienne. Les noeuds A, B, C, D, E, F, M sont sur la même ligne et les noeuds A, G, H, I, J, K, M sont sur la même ligne. L'on suppose que au noeud G apparaît un défaut 3 monophasé (phase-terre), puis un défaut 3 biphasé.
Les tensions directe et inverse en pourcentage de leurs valeurs nominales sont respectivement présentées sur les figures 9a et 9b. Notamment, on notera qu'au noeud où le défaut 3 apparaît (le noeud G), le premier minimum en taux de tensions directes de la ligne en référence à la figure 9a correspond au premier maximum en taux de tensions inverses en référence à la figure 9b.
Maintenant, on considère un réseau arborescent 5 en référence à la figure 10. De l'amont vers l'aval, le réseau 5 comporte une source 4a très haute tension V1, un poste source 7 (transformateur haute-moyenne tension), une pluralité de lignes constituant l'arborescence pour avoir au total 22 lignes et 21 postes HTA-BT avec 200 kW de charge qui sont à divers endroits d'arborescences, soient de P1 à P21. Dans cet exemple, on suppose qu'un défaut de type monophasé (phase-terre) avec ou sans rupture de conducteur, ou biphasé avec ou sans rupture de conducteur, ou triphasé avec ou sans rupture de conducteur, apparaît entre les postes P14 et P15, sachant que les postes P15 à P21 sont sur la même branche de l'arborescence.
Un résultat de taux de tension pour un mode de mise à la terre du neutre résistif de 40 Ohms du transformateur du poste source 7 est traité. Cette fois-ci encore, à l'endroit où le défaut 3 se trouve (entre postes P14 et P15), le premier minimum en taux de tensions directes correspond au premier maximum en taux de tensions inverses comme le montrent les figures 11a à 11m.
Les figures 11a à 11m démontrent que le procédé de détection et de localisation de défaut proposé dans le cadre de la présente invention est opérationnel tant pour des défauts sans rupture de conducteur que pour des défauts résultant de la rupture d'au moins un conducteur.
Par ailleurs, on note que les valeurs des taux de tensions sont les mêmes pour tous les postes 9 en aval du défaut (P15 à P21), et donc pour ces tronçons les évolutions de tension ou de taux de tension sont nulles. Ce résultat est concordant avec le fait que le réseau non-maillé 5 ne comporte qu'une source 4a et que le défaut 3 se situe en amont du point de mesure.
Ces résultats prouvent que le procédé et le système selon l'invention permettent de localiser la position du défaut 3 en recherchant l'extrémum de tensions inverse et/ou directe, pour deux types de topologie de réseau : réseau maillé 4 et réseau non-maillé 5.
Bien entendu la présente invention n'est pas limitée aux modes de réalisation qui viennent d'être décrits, mais s'étend à toutes variantes conformes aux revendications annexes.

### Revendications

1. Système de détection d'un défaut (3) dans un réseau électrique polyphasé (4, 5), le système comprenant une pluralité de capteurs répartis sur le réseau (4, 5) électrique et adaptés pour mesurer au niveau de chaque capteur respectif un taux de tension directe égal au rapport entre la tension directe au niveau du capteur et la tension nominale du réseau et un taux de tension inverse égal au rapport entre la tension inverse au niveau du capteur et la tension nominale du réseau et des moyens d'analyse adaptés pour analyser les signaux issus des différents capteurs **caractérisé en ce que** les moyens d'analyse sont configurés pour :

- calculer, pour chaque portion de réseau délimitée par deux points de mesure m et n, l'évolution des taux directs EVOL_D et l'évolution des taux inverses EVOL_I par unité de longueur, définies respectivement par :

$$EVOL\_D = \frac{Taux\_D_{(m)} - Taux\_D(n)}{L(m,n)}$$

et

$$EVOL\_I = \frac{Taux\_I_{(m)} - Taux\_I(n)}{L(m,n)},$$

où $L(m, n)$ est la longueur de la portion de réseau délimitée par les points de mesure m et n, $Taux\_D(m)$ est le taux de tension directe correspondant au rapport entre la tension directe au point de mesure m et la tension nominale du réseau, $Taux\_D(n)$ est le taux de tension directe correspondant au rapport entre la tension directe au point de mesure n et la tension nominale du réseau, $Taux\_I(m)$ est le taux de tension inverse correspondant au rapport entre la tension inverse au point de mesure m et la tension nominale du réseau et $Taux\_I(n)$ est le taux de tension inverse correspondant au rapport entre la tension inverse au point de mesure n et la tension nominale du réseau ;
- si un taux de tension inverse mesuré au niveau d'un capteur est supérieur à un premier seuil :

  ∘ rechercher le maximum des taux de tension inverse mesurés au niveau de chaque capteur pour localiser un défaut (3) au niveau du capteur correspondant à ce maximum ;
  ∘ si les évolutions des taux inverses EVOL_I des portions de réseau raccordées au point de mesure du maximum sont supérieures à un deuxième seuil, déterminer que le défaut est situé à proximité du point de mesure du maximum sur l'une des portions raccordées au point de mesure du maximum ;
  ∘ si l'évolution des taux inverses EVOL_I d'au moins une portion de réseau raccordées au point de mesure du maximum est inférieure au deuxième seuil, déterminer que le défaut est situé :

    ▪ à proximité du point de mesure du maximum sur l'une des portions raccordées au point de mesure du maximum, dans le cas d'un réseau maillé ;
    ▪ sur l'une des portions raccordées au point de mesure du maximum du côté de la source par rapport au point de mesure du maximum, dans le cas d'un réseau arborescent non maillé ;

- si aucun des taux de tension inverse mesurés au niveau des capteurs n'est supérieur au premier seuil et si un taux de tension directe mesuré au niveau d'un capteur est inférieur à un troisième seuil :

  ∘ rechercher le minimum des taux de tension directe mesurés au niveau de chaque capteur pour localiser un défaut (3) au niveau du capteur correspondant à ce minimum ;
  ∘ si les évolutions des taux direct EVOL_D des portions de réseau raccordées au point de mesure du minimum sont supérieures au deuxième seuil, déterminer que le défaut est situé à proximité du point de mesure du minimum sur l'une des portions raccordées au point de mesure du minimum ;
  ∘ si l'évolution des taux directs EVOL_D d'au moins une portion de réseau raccordées au point de mesure du minimum est inférieure au deuxième seuil, déterminer que le défaut est situé :

    ▪ à proximité du point de mesure du minimum sur l'une des portions raccordées au point de mesure du minimum, dans le cas d'un réseau maillé ;
    ▪ sur l'une des portions raccordées au point de mesure du minimum du côté de la source par rapport au point de mesure du minimum, dans le cas d'un réseau arborescent non maillé.

2. Procédé de détection d'un défaut (3) dans un réseau électrique (4, 5) moyenne et/ou basse tension, le procédé comprenant les étapes qui consistent à :

- mesurer, au niveau de chaque capteur d'une pluralité de capteurs répartis sur le réseau électrique (4, 5), un taux de tension directe égal au rapport entre la tension directe au niveau du capteur et la tension nominale du réseau et un taux de tension inverse égal au rapport entre la tension inverse au niveau du capteur et la tension nominale du réseau, le procédé **caractérisé en ce qu'**il comprend les étapes suivantes :
- calculer, pour chaque portion de réseau délimitée par deux points de mesure m et n, l'évolution des taux directs EVOL_D et l'évolution des taux inverses EVOL_I par unité de longueur, définies respectivement par :

$$EVOL\_D = \frac{Taux\_D_{(m)} - Taux\_D(n)}{L(m,n)}$$

et

$$EVOL\_I = \frac{Taux\_I_{(m)} - Taux\_I(n)}{L(m,n)},$$

où $L(m, n)$ est la longueur de la portion de réseau délimitée par les points de mesure m et n, $Taux\_D(m)$ est le taux de tension directe correspondant au rapport entre la tension directe au point de mesure m et la tension nominale du réseau, $Taux\_D(n)$ est le taux de tension directe correspondant au rapport entre la tension directe au point de mesure n et la tension nominale du réseau, $Taux\_I(m)$ est le taux de tension inverse correspondant au rapport entre la tension inverse au point de mesure m et la tension nominale du réseau et $Taux\_I(n)$ est le taux de tension inverse correspondant au rapport entre la tension inverse au point de mesure n et la tension nominale du réseau ;

- si un taux de tension inverse mesuré au niveau d'un capteur est supérieur à un premier seuil :

 ∘ rechercher le maximum des taux de tension inverse mesurés au niveau de chaque capteur pour localiser un défaut (3) au niveau du capteur correspondant à ce maximum ;
 ∘ si les évolutions des taux inverses EVOL_I des portions de réseau raccordées au point de mesure du maximum sont supérieures à un deuxième seuil, déterminer que le défaut est situé à proximité du point de mesure du maximum sur l'une des portions raccordées au point de mesure du maximum ;
 ∘ si l'évolution des taux inverses EVOL_I d'au moins une portion de réseau raccordées au point de mesure du maximum est inférieure au deuxième seuil, déterminer que le défaut est situé :

  ▪ à proximité du point de mesure du maximum sur l'une des portions raccordées au point de mesure du maximum, dans le cas d'un réseau maillé ;
  ▪ sur l'une des portions raccordées au point de mesure du maximum du côté de la source par rapport au point de mesure du maximum, dans le cas d'un réseau arborescent non maillé ;

- si aucun des taux de tension inverse mesurés au niveau des capteurs n'est supérieur au premier seuil et si un taux de tension directe mesuré au niveau d'un capteur est inférieur à un troisième seuil :

 ∘ rechercher le minimum des taux de tension directe mesurés au niveau de chaque capteur pour localiser un défaut (3) au niveau du capteur correspondant à ce minimum ;
 ∘ si les évolutions des taux direct EVOL_D des portions de réseau raccordées au point de mesure du minimum sont supérieures au deuxième seuil, déterminer que le défaut est situé à proximité du point de mesure du minimum sur l'une des portions raccordées au point de mesure du minimum ;
 ∘ si l'évolution des taux directs EVOL_D d'au moins une portion de réseau raccordées au point de mesure du minimum est inférieure au deuxième seuil, déterminer que le défaut est situé :

  ▪ à proximité du point de mesure du minimum sur l'une des portions raccordées au point de mesure du minimum, dans le cas d'un réseau maillé ;
  ▪ sur l'une des portions raccordées au point de mesure du minimum du côté de la source par rapport au point de mesure du minimum, dans le cas d'un réseau arborescent non maillé.

3. Procédé selon la revendication 2, **caractérisé par le fait que** chaque capteur mesure les trois tensions phase-neutre du réseau (4, 5) ou les trois tensions phase-phase du réseau (4, 5).

4. Procédé selon l'une des revendications 2 et 3, **caractérisé par le fait que** l'étape d'analyse exploite la Transformée de Fortescue.

5. Procédé selon l'une des revendications 2 à 4, **caractérisé par le fait qu'**il est mis en oeuvre *a posteriori* après mise hors tension du réseau (4, 5).

6. Procédé selon l'une des revendications 2 à 4, **caractérisé par le fait qu'**il est mis en oeuvre en temps réel pour commander des organes de coupure électrique.

7. Procédé selon l'une des revendications 2 à 6, **caractérisé par le fait qu'**il est mis en oeuvre par mesure directement sur une ligne protégée.

8. Procédé selon l'une des revendications 2 à 6, **caractérisé par le fait qu'**il est mis en oeuvre par mesure sur un point de réseau (4, 5) connecté à une ligne protégée.

**9.** Procédé selon l'une des revendications 2 à 8, **caractérisé par le fait qu'**il est mis en oeuvre par mesure au niveau de concentrateurs installés dans des postes HTA/BT (9).

**10.** Procédé selon l'une des revendications 2 à 8, **caractérisé par le fait qu'**il est mis en oeuvre par mesure au niveau de compteurs intelligents basse tension triphasés installés au niveau d'utilisateurs connectés au réseau (4, 5).

**11.** Procédé selon l'une des revendications 2 à 10, **caractérisé par le fait qu'**il est mis en oeuvre par mesure au niveau d'une pluralité de points de mesure répartis sur le réseau (4, 5) et envoi des signaux issus des capteurs répartis sur le réseau (4, 5) à un calculateur décentralisé (9) qui opère l'étape d'analyse.

**12.** Procédé selon l'une des revendications 2 à 11, **caractérisé par le fait que** les étapes de mesure et d'analyse sont mises en oeuvre avec un pas de l'ordre de 400 ms pour un réseau (5) moyenne tension HTA.

**13.** Procédé selon l'une des revendications 2 à 11, **caractérisé par le fait que** les étapes de mesure et d'analyse sont mises en oeuvre avec un pas de l'ordre de quelques secondes pour réseau (5) basse tension BT protégé par des fusibles.

**14.** Procédé selon l'une des revendications 2 à 11, **caractérisé par le fait que** les étapes de mesure et d'analyse sont mises en oeuvre avec un pas inférieur à la temporisation de relais de protection placés sur le réseau (4, 5).

**15.** Réseau d'électricité (4, 5) polyphasé, **caractérisé par le fait qu'**il comprend une pluralité de capteurs répartis sur le réseau (4, 5) et adaptés pour mesurer un paramètre représentatif de la tension directe et/ou de la tension inverse au niveau de chaque capteur respectif et des moyens d'analyse adaptés pour analyser les signaux issus des différents capteurs représentatifs de la tension directe et/ou de la tension inverse au niveau de chaque capteur respectif, en recherchant un extremum parmi les signaux issus des capteurs et pour localiser un défaut au niveau du capteur correspondant à cet extremum comprenant un système de détection de défaut conforme à la revendication 1 ou des moyens adaptés pour mettre en oeuvre le procédé conforme à l'une des revendications 2 à 14.

**Patentansprüche**

**1.** System zur Erkennung eines Fehlers (3) in einem mehrphasigen elektrischen Netz (4, 5), wobei das System eine Vielzahl von Sensoren umfasst, die in dem elektrischen Netz (4, 5) verteilt und geeignet sind, an jedem jeweiligen Sensor eine Vorwärtsspannungsrate zu messen, die gleich dem Verhältnis zwischen der Vorwärtsspannung am Sensor und der Nennspannung des Netzes ist und eine Sperrspannungsrate, die gleich dem Verhältnis zwischen der Sperrspannung am Sensor und der Nennspannung des Netzes ist und Analysemittel, die geeignet sind, die von den verschiedenen Sensoren stammenden Signale zu analysieren, **dadurch gekennzeichnet, dass** die Analysemittel ausgelegt sind, um:

- für jeden von zwei Messpunkten m und n begrenzten Netzabschnitt die Entwicklung der Vorwärtsraten EVOL_D und die Entwicklung der Sperrraten EVOL_I je Längeneinheit zu berechnen, die jeweils definiert sind durch:

$$EVOL\_D = \frac{Taux\_D_{(m)} - Taux\_D(n)}{L(m, n)}$$

und

$$EVOL\_I = \frac{Taux\_I_{(m)} - Taux\_I(n)}{L(m,n)},$$

wobei *L(m,n)* die Länge des Netzabschnitts ist, der von den Messpunkten m und n begrenzt ist, *Taux_D(m)* die Vorwärtsspannungsrate ist, die dem Verhältnis zwischen der Vorwärtsspannung am Messpunkt m und der Nennspannung des Netzes entspricht; *Taux_D(n)* die Vorwärtsspannungsrate ist, die dem Verhältnis zwischen der Vorwärtsspannung am Messpunkt n und der Nennspannung des Netzes entspricht, *Taux_I(m)* die Sperrspannungsrate ist, die dem Verhältnis zwischen der Sperrspannung am Messpunkt m und der Nennspannung des Netzes entspricht und *Taux_I(n)* die Sperrspannungsrate ist, die dem Verhältnis zwischen der Sperrspannung am Messpunkt n und der Nennspannung des Netzes entspricht;
- wenn eine an einem Sensor gemessene Sperrspannungsrate höher als ein erster Grenzwert ist:

○ das Maximum der Sperrspannungsraten zu ermitteln, die an jedem Sensor gemessen wurden, um einen Fehler (3) am Sensor zu lokalisieren, der diesem Maximum entspricht,

◦ wenn die Entwicklungen der Sperrraten EVOL_I der Netzabschnitte, die mit dem Messpunkt des Maximums verbunden sind, höher sind als ein zweiter Grenzwert, zu bestimmen, dass sich der Fehler in der Nähe des Messpunkts des Maximums in einem der Abschnitte befindet, die mit dem Messpunkt des Maximums verbunden sind;

◦ wenn die Entwicklung der Sperrraten EVOL_I mindestens eines Netzabschnitts, die mit dem Messpunkt des Maximums verbunden sind, niedriger als ein zweiter Grenzwert ist, zu bestimmen, dass sich der Fehler befindet:

■ in der Nähe des Messpunkts des Maximums in einem der Abschnitte, die mit dem Messpunkt des Maximums verbunden sind, im Fall eines Mesh-Netzes;

■ in einem der Abschnitte, die mit dem Messpunkt des Maximums auf der Seite der Quelle in Bezug auf den Messpunkt des Maximums verbunden sind, im Fall eines nicht-gemeshten Baumnetzes;

- wenn keine der an den Sensoren gemessenen Sperrspannungsraten höher als der erste Grenzwert ist und wenn eine an einem Sensor gemessene Vorwärtsspannungsrate niedriger als ein dritter Grenzwert ist:

◦ das Minimum der Vorwärtsspannungsraten zu ermitteln, die an jedem Sensor gemessen wurden, um einen Fehler (3) am Sensor zu lokalisieren, der diesem Minimum entspricht,

◦ wenn die Entwicklungen der Vorwärtsraten EVOL_D der Netzabschnitte, die mit dem Messpunkt des Minimums verbunden sind, höher sind als der zweite Grenzwert, zu bestimmen, dass sich der Fehler in der Nähe des Messpunkts des Minimums in einem der Abschnitte befindet, die mit dem Messpunkt des Minimums verbunden sind;

◦ wenn die Entwicklung der Vorwärtsraten EVOL_D mindestens eines Netzabschnitts, die mit dem Messpunkt des Minimums verbunden sind, niedriger als der zweite Grenzwert ist, zu bestimmen, dass sich der Fehler befindet:

■ in der Nähe des Messpunkts des Minimums in einem der Abschnitte, die mit dem Messpunkt des Minimums verbunden sind, im Fall eines Mesh-Netzes;

■ in einem der Abschnitte, die mit dem Messpunkt des Minimums auf der Seite der Quelle in Bezug auf den Messpunkt des Minimums verbunden sind, im Fall eines nicht-gemeshten Baumnetzes.

2. Verfahren zur Erkennung eines Fehlers (3) in einem elektrischen Mittel- und/oder Niederspannungsnetz (4, 5), wobei das Verfahren die Schritte umfasst, die darin bestehen:

- Messen, an jedem Sensor einer Vielzahl von Sensoren, die in dem elektrischen Netz (4, 5) verteilt sind, einer Vorwärtsspannungsrate, die gleich dem Verhältnis zwischen der Vorwärtsspannung am Sensor und der Nennspannung des Netzes ist und einer Sperrspannungsrate, die gleich dem Verhältnis zwischen der Sperrspannung am Sensor und der Nennspannung des Netzes ist, wobei das Verfahren **dadurch gekennzeichnet ist, dass** es die folgenden Schritte umfasst:

- Berechnen, für jeden von zwei Messpunkten m und n begrenzten Netzabschnitt, der Entwicklung der Vorwärtsspannungsraten EVOL_D und der Entwicklung der Sperrspannungsraten EVOL_I je Längeneinheit, die jeweils definiert sind durch:

$$EVOL\_D = \frac{Taux\_D_{(m)} - Taux\_D(n)}{L(m,\, n)}$$

und

$$EVOL\_I = \frac{Taux\_I_{(m)} - Taux\_I(n)}{L(m,n)},$$

wobei *L(m,n)* die Länge des Netzabschnitts ist, der von den Messpunkten m und n begrenzt ist, *Taux_D(m)* die Vorwärtsspannungsrate ist, die dem Verhältnis zwischen der Vorwärtsspannung am Messpunkt m und der Nennspannung des Netzes entspricht; *Taux_D(n)* die Vorwärtsspannungsrate ist, die dem Verhältnis zwischen der Vorwärtsspannung am Messpunkt n und der Nennspannung des Netzes entspricht, *Taux_I(m)* die Sperrspannungsrate ist, die dem Verhältnis zwischen der Sperrspannung am Messpunkt m und der Nennspannung des Netzes entspricht und *Taux_I(n)* die Sperrspannungsrate ist, die dem Verhältnis zwischen der Sperrspannung am Messpunkt n und der Nennspannung des Netzes entspricht;

- wenn eine an einem Sensor gemessene Sperrspannungsrate höher als ein erster Grenzwert ist:

° das Maximum der Sperrspannungsraten zu ermitteln, die an jedem Sensor gemessen wurden, um einen Fehler (3) am Sensor zu lokalisieren, der diesem Maximum entspricht,

° wenn die Entwicklungen der Sperrraten EVOL_I der Netzabschnitte, die mit dem Messpunkt des Maximums verbunden sind, höher sind als ein zweiter Grenzwert, zu bestimmen, dass sich der Fehler in der Nähe des Messpunkts des Maximums in einem der Abschnitte befindet, die mit dem Messpunkt des Maximums verbunden sind;

° wenn die Entwicklung der Sperrraten EVOL_I mindestens eines Netzabschnitts, die mit dem Messpunkt des Maximums verbunden sind, niedriger als der zweite Grenzwert ist, zu bestimmen, dass sich der Fehler befindet:

▪ in der Nähe des Messpunkts des Maximums in einem der Abschnitte, die mit dem Messpunkt des Maximums verbunden sind, im Fall eines Mesh-Netzes;

▪ in einem der Abschnitte, die mit dem Messpunkt des Maximums auf der Seite der Quelle in Bezug auf den Messpunkt des Maximums verbunden sind, im Fall eines nicht-gemeshten Baumnetzes;

- wenn keine der an den Sensoren gemessenen Sperrspannungsraten höher als der erste Grenzwert ist und wenn eine an einem Sensor gemessene Vorwärtsspannungsrate niedriger als ein dritter Grenzwert ist:

° das Minimum der Vorwärtsspannungsraten zu ermitteln, die an jedem Sensor gemessen wurden, um einen Fehler (3) am Sensor zu lokalisieren, der diesem Minimum entspricht,

° wenn die Entwicklungen der Vorwärtsraten EVOL_D der Netzabschnitte, die mit dem Messpunkt des Minimums verbunden sind, höher sind als der zweite Grenzwert, zu bestimmen, dass sich der Fehler in der Nähe des Messpunkts des Minimums in einem der Abschnitte befindet, die mit dem Messpunkt des Minimums verbunden sind;

° wenn die Entwicklung der Vorwärtsraten EVOL_D mindestens eines Netzabschnitts, die mit dem Messpunkt des Minimums verbunden sind, niedriger als der zweite Grenzwert ist, zu bestimmen, dass sich der Fehler befindet:

▪ in der Nähe des Messpunkts des Minimums in einem der Abschnitte, die mit dem Messpunkt des Minimums verbunden sind, im Fall eines Mesh-Netzes;

▪ in einem der Abschnitte, die mit dem Messpunkt des Minimums auf der Seite der Quelle in Bezug auf den Messpunkt des Minimums verbunden sind, im Fall eines nicht-gemeshten Baumnetzes.

3. Verfahren nach Anspruch 2, **dadurch gekennzeichnet, dass** jeder Sensor die drei Phase-Neutral-Spannungen des Netzes (4, 5) oder die drei Phase-Phase-Spannungen des Netzes (4, 5) misst.

4. Verfahren nach einem der Ansprüche 2 und 3, **dadurch gekennzeichnet, dass** der Analyseschritt die Fortescue-Transformation verwendet.

5. Verfahren nach einem der Ansprüche 2 bis 4, **dadurch gekennzeichnet, dass** es *a posteriori* nach dem Ausschalten des Netzes (4, 5) durchgeführt wird.

6. Verfahren nach einem der Ansprüche 2 bis 4, **dadurch gekennzeichnet, dass** es in Echtzeit durchgeführt wird, um elektrische Abschaltorgane zu steuern.

7. Verfahren nach einem der Ansprüche 2 bis 6, **dadurch gekennzeichnet, dass** es durch Messung direkt auf einer geschützten Leitung durchgeführt wird.

8. Verfahren nach einem der Ansprüche 2 bis 6, **dadurch gekennzeichnet, dass** es durch Messung an einem Netzpunkt (4, 5) durchgeführt wird, der mit einer geschützten Leitung verbunden ist.

9. Verfahren nach einem der Ansprüche 2 bis 8, **dadurch gekennzeichnet, dass** es durch Messung an in HS/NS-Stationen (9) installierten Konzentratoren durchgeführt wird.

10. Verfahren nach einem der Ansprüche 2 bis 8, **dadurch gekennzeichnet, dass** es durch Messung an intelligenten Dreiphasen-Niederspannungszählern durchgeführt wird, die an mit dem Netz verbundenen Verbrauchern (4, 5) installiert sind.

11. Verfahren nach einem der Ansprüche 2 bis 10, **dadurch gekennzeichnet, dass** es durch Messen an einer Vielzahl von über das Netz (4, 5) verteilten Messpunkten und Senden der Signale von den über das Netz (4, 5) verteilten Sensoren an einen dezentralen Rechner (9), der den Analyseschritt ausführt, durchgeführt wird.

12. Verfahren nach einem der Ansprüche 2 bis 11, **dadurch gekennzeichnet, dass** der Mess- und Analyseschritt mit einer Schrittweite in der Größenordnung von 400 ms für ein Mittelspannungs-Hochspannungsnetz (5) durchgeführt werden.

13. Verfahren nach einem der Ansprüche 2 bis 11, **dadurch gekennzeichnet, dass** der Mess- und Analyseschritt mit einer Schrittweite in der Größenordnung von einigen Sekunden für ein durch Sicherungen geschütztes Niederspannungsnetz (5) durchgeführt werden.

14. Verfahren nach einem der Ansprüche 2 bis 11, **dadurch gekennzeichnet, dass** der Mess- und Analyseschritte mit einer Schrittweite durchgeführt werden, der niedriger ist als die Verzögerungszeit von Schutzrelais, die im Netz (4, 5) platziert sind.

15. Mehrphasiges Stromnetz (4, 5), **dadurch gekennzeichnet, dass** es eine Vielzahl von Sensoren umfasst, die über das Netz (4, 5) verteilt und geeignet sind, einen Parameter zu messen, der für die Vorwärtsspannung und/oder die Sperrspannung an jedem jeweiligen Sensor repräsentativ ist, und Analysemittel, die geeignet sind, die von den verschiedenen Sensoren stammenden Signale zu analysieren, die für die Vorwärtsspannung und/oder die Sperrspannung an jedem jeweiligen Sensor repräsentativ sind, durch Ermitteln eines Extremums unter den von den Sensoren stammenden Signalen und zum Lokalisieren eines Fehlers im Bereich des Sensors, der diesem Extremum entspricht, umfassend ein System zur Fehlerermittlung nach Anspruch 1 oder Mittel, die geeignet sind, das Verfahren nach einem der Ansprüche 2 bis 14 durchzuführen.

**Claims**

1. A system for detecting a fault (3) in a polyphase electrical network (4, 5), the system comprising a plurality of sensors distributed over the electrical network (4, 5) and adapted to measure at each respective sensor a positive sequence voltage ratio equal to the ratio between the positive sequence voltage at the sensor and the nominal network voltage and a negative sequence voltage ratio equal to the ratio between the negative sequence voltage at the sensor and the nominal network voltage and analysis means adapted to analyse the signals from the various sensors **characterised in that** the analysis means are configured to :

    - calculate, for each network portion delimited by two measurement points m and n, the variation of positive sequence rates EVOL_D and of negative sequence rates EVOL_I per unit length, defined respectively by :

$$EVOL\_D = \frac{Taux\_D_{(m)} - Taux\_D(n)}{L(m,n)}$$

and

$$EVOL\_I = \frac{Taux\_I_{(m)} - Taux\_I(n)}{L(m,n)},$$

where $L(m,n)$ is the length of the network portion between the measuring points m and n, $Taux\_D(m)$ is the positive sequence voltage rate corresponding to the ratio between the positive sequence voltage at the measuring point m and the nominal network voltage, $Taux\_D(n)$ is the positive sequence voltage rate corresponding to the ratio between the positive sequence at the measuring point n and the nominal network voltage, $Taux\_I(m)$ is the negative sequence voltage rate corresponding to the ratio between the negative sequence voltage at the measuring point m and the nominal network voltage, and $Taux\_I(n)$ is the negative sequence voltage rate corresponding to the ratio between the negative sequence voltage at the measuring point n to the nominal network voltage;

- if a negative sequence voltage rate measured at a sensor exceeds a first threshold :

    ∘ find the maximum of the negative sequence voltage rates measured at each sensor to locate a fault (3) at the sensor corresponding to this maximum;
    ∘ if the variations in the negative sequence rates EVOL_I of the network portions connected to the maximum measurement point are greater than a second threshold, determine that the fault is located near the maximum measurement point on one of the portions connected to the maximum measurement point;
    ∘ if the variation of the negative sequence rates EVOL_I of at least one network portion connected to the maximum measurement point is below the second threshold, determine that the fault is located :

        • close to the maximum measurement point on one of the portions connected to the maximum measurement point, in the case of a meshed network;
        • on one of the portions connected to the maximum measurement point on the source side with respect to the maximum measurement point, in the case of a non-meshed tree network;

- if none of the negative sequence voltage rates measured at the sensors is greater than the first threshold, and if a positive sequence voltage rate measured at a sensor is less than a third threshold:

    ◦ find the minimum of the positive sequence voltage rates measured at each sensor to locate a fault (3) at the sensor corresponding to this minimum;
    ◦ if the evolutions in the positive sequence rates EVOL_D of the network portions connected to the minimum measurement point are greater than the second threshold, determine that the fault is located near the minimum measurement point on one of the portions connected to the minimum measurement point;
    ◦ if the evolution of the positive sequence rates EVOL_D of at least one network portion connected to the minimum measurement point is below the second threshold, determine that the fault is located :

        • close to the minimum measurement point on one of the portions connected to the minimum measurement point, in the case of a meshed network;
        • on one of the portions connected to the minimum measurement point on the source side with respect to the minimum measurement point, in the case of a non-meshed tree network.

2. A method of detecting a fault (3) in a medium and/or low voltage electrical network (4, 5), the method comprising the steps of:

    - measuring, at each sensor of a plurality of sensors distributed over the electrical network (4, 5), a positive sequence voltage ratio equal to the ratio between the positive sequence voltage at the sensor and the nominal network voltage and a negative sequence voltage ratio equal to the ratio between the negative sequence voltage at the sensor and the nominal network voltage, the method being **characterized in that** it comprises the following steps:
    - calculate, for each network portion delimited by two measuring points m and n, the evolution in positive sequence rate EVOL_D and the evolution in negative sequence rate EVOL_I per unit length, defined respectively by :

$$EVOL\_D = \frac{Taux\_D_{(m)} - Taux\_D(n)}{L(m,n)}$$

and

$$EVOL\_I = \frac{Taux\_I_{(m)} - Taux\_I(n)}{L(m,n)},$$

where $L(m,n)$ is the length of the network portion bounded by the measuring points m and n, $Taux\_D(m)$ is the positive sequence voltage rate corresponding to the ratio between the positive sequence voltage at the measuring point m and the nominal network voltage, $Taux\_D(n)$ is the positive sequence voltage rate corresponding to the ratio between the positive sequence voltage at the measuring point n and the nominal network voltage, $Taux\_I(m)$ is the negative sequence voltage rate corresponding to the ratio between the negative sequence voltage at the measuring point m and the nominal network voltage, and $Taux\_I(n)$ is the negative sequence voltage rate corresponding to the ratio between the negative sequence voltage at the measuring point n and the nominal network voltage;
- if a negative sequence voltage rate measured at a sensor exceeds a first threshold :

    ◦ find the maximum of the negative sequence voltage rates measured at each sensor to locate a fault (3) at the sensor corresponding to this maximum;
    ◦ if the evolutions in the negative sequence rates EVOL_I of the network portions connected to the maximum measurement point are greater than a second threshold, determine that the fault is located near the maximum measurement point on one of the portions connected to the maximum measurement point;
    ◦ if the evolution of the negative sequence rates EVOL_I of at least one network portion connected to the maximum measurement point is below the second threshold, determine that the fault is located :

        • close to the maximum measurement point on one of the portions connected to the maximum measurement point, in the case of a meshed network;
        • on one of the portions connected to the maximum measurement point on the source side with respect to the maximum measurement point, in the case of a non-meshed tree network;

- if none of the negative sequence voltage rates measured at the sensors exceeds the first threshold and if a positive sequence voltage rate measured at a sensor is below a third threshold :

    ○ find the minimum of the positive sequence voltage rates measured at each sensor to locate a fault (3) at the sensor corresponding to this minimum;
    ○ if the evolutions in the positive sequence rates EVOL_D of the network portions connected to the minimum measurement point are greater than the second threshold, determine that the fault is located near the minimum measurement point on one of the portions connected to the minimum measurement point;
    ○ if the evolution of the positive sequence rates EVOL_D of at least one network portion connected to the minimum measurement point is below the second threshold, determine that the fault is located :

        • close to the minimum measurement point on one of the portions connected to the minimum measurement point, in the case of a meshed network;
        • on one of the portions connected to the minimum measurement point on the source side with respect to the minimum measurement point, in the case of a non-meshed tree network.

3. Process according to claim 2, **characterized by** the fact that each sensor measures the three phase-to-neutral voltages of the network (4, 5) or the three phase-to-phase voltages of the network (4, 5).

4. Process according to one of claims 2 and 3, **characterized in that** the analysis step uses the Fortescue Transform.

5. Process according to one of claims 2 to 4, **characterized by** the fact that it is carried out *a posteriori* after de-energizing the network (4, 5).

6. Method according to one of claims 2 to 4, **characterized by** the fact that it is implemented in real time to control electrical switching devices.

7. Process according to one of claims 2 to 6, **characterized in that** it is carried out by measurement directly on a protected line.

8. Method according to one of claims 2 to 6, **characterized by** the fact that it is implemented by measurement on a network point (4, 5) connected to a protected line.

9. Process according to one of claims 2 to 8, **characterized in that** it is implemented by measurement at concentrators installed in MV/LV substations (9).

10. Process according to one of claims 2 to 8, **characterized by** the fact that it is implemented by measurement at three-phase low-voltage smart meters installed at users connected to the network (4, 5).

11. Process according to one of claims 2 to 10, **characterized in that** it is implemented by measuring at a plurality of measuring points distributed over the network (4, 5) and sending the signals from the sensors distributed over the network (4, 5) to a decentralized computer (9) which performs the analysis step.

12. Method according to one of claims 2 to 11, **characterized in that** the measurement and analysis steps are carried out with a step size of the order of 400 ms for a medium-voltage MV network (5).

13. Method according to one of claims 2 to 11, **characterized by** the fact that the measurement and analysis steps are carried out with a step size of the order of a few seconds for a low-voltage LV network (5) protected by fuses.

14. Method according to one of claims 2 to 11, **characterized by** the fact that the measurement and analysis steps are carried out with a step size smaller than the time lag of protective relays placed on the network (4, 5).

15. Multiphase electricity network (4, 5), **characterized in that** it comprises a plurality of sensors distributed over the network (4, 5) and adapted to measure a parameter representative of the positive sequence voltage and/or the negative sequence voltage at each respective sensor and analysis means adapted to analyze the signals from the various sensors representative of the positive sequence voltage and/or the negative sequence voltage at each respective sensor, by searching for an extremum among the signals from the sensors and to locate a fault at the sensor corresponding to this extremum comprising a fault detection system according to claim 1 or means adapted to implement the method according to one of claims 2 to 14.

**FIG. 1**
État de la technique

**FIG. 2**
État de la technique

# FIG. 3
## État de la technique

EP 3 814 788 B1

**FIG. 4**
**État de la technique**

**FIG. 5**

EP 3 814 788 B1

FIG. 6

**FIG. 7**

100 — (Taux_I > TAUX_I_MIN)

OUI →

102 — Recherche du Maximum.
Le point de mesure est point Imax.
On regarde les valeurs des EVOL_I sur chaque portion raccordée à point_I max.

Au moins une valeur de EVOL_I est nulle ou < Delta_EVOL_Taux

OUI →

104 — Le réseau est maillé

OUI →

108 — Le défaut est sur l'un des tronçons raccordés au point_I max

NON →

106 — Le défaut est sur l'un des tronçons raccordés au point I_max : du côté de la source

NON (from 100) →

110 — (Taux_D > TAUX_D_MIN)

NON → (retour)

OUI →

112 — Recherche du Minimum.
Le point de mesure est point_Dmin.
On regarde les valeurs des EVOL_D sur chaque portion raccordée à point_Dmin.

Au moins une valeur de EVOL_D est nulle ou < Delta_EVOL_Taux

OUI →

114 — Le réseau est maillé

OUI →

118 — Le défaut est sur l'un des tronçons raccordés au point_Dmin

NON →

116 — Le défaut est sur l'un des tronçons raccordés au point_Dmin : du côté de la source

FIG. 8

## FIG. 9a
### Tensions directes

**■ Vd défaut monophasé**   **□ Vd défaut Biphasé**   **▨ Vd défaut triphasé**

| I |   | II |   | III |

## FIG. 9b
### Tensions inverses

**■ Vi défaut monophasé**   **□ Vi défaut Biphasé**

| I |   | II |

FIG. 10

**FIG. 11a**

**FIG. 11b**

FIG. 11c

Type 3

a
b
c

Terre

Taux

100%
90%
80%
70%
60%
50%
40%
30%
20%
10%
0%

1 2 3 4 5 6 7 8 9 10 11 12 13 14 15 16 17 18 19 20 21

Point de mesure

○ Taux D
△ Taux I

FIG. 11d

Type 4

a
b
c

Terre

Taux

100%
90%
80%
70%
60%
50%
40%
30%
20%
10%
0%

1 2 3 4 5 6 7 8 9 10 11 12 13 14 15 16 17 18 19 20 21

Point de mesure

○ Taux D
△ Taux I

EP 3 814 788 B1

## FIG. 11e

Type 5

## FIG. 11f

Type 6

EP 3 814 788 B1

FIG. 11g

Type 7

FIG. 11h

Type 8

EP 3 814 788 B1

FIG. 11i

Type 9

Point de mesure

○ Taux D
△ Taux I

FIG. 11j

Type 10

Point de mesure

○ Taux D
△ Taux I

EP 3 814 788 B1

FIG. 11k

Type 11

Terre

FIG. 11l

Type 12

Terre

EP 3 814 788 B1

## FIG. 11m

**Type 13**

a —•
b —•
c —•

*Terre*

Taux

- 100%
- 90%
- 80%
- 70%
- 60%
- 50%
- 40%
- 30%
- 20%
- 10%
- 0%

Point de mesure: 1 2 3 4 5 6 7 8 9 10 11 12 13 14 15 16 17 18 19 20 21

○ Taux D
△ Taux I

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- FR 2976363
- EP 2533060 A
- FR 3028620
- FR 2936378
- US 2008097706 A
- JP 2004061142 A
- US 2017336465 A
- EP 0933643 A
- DE 3636367
- IE S20050382